# EUROPÄISCHE PATENTANMELDUNG

(11) **EP 2 708 904 A2**
(43) Veröffentlichungstag der Anmeldung: **19.03.2014**
(21) Anmeldenummer: 13183070.5
(22) Anmeldetag: 05.09.2013
(51) Int. Cl.: G01R 19/15

(54) **Vorrichtung zur Ermittlung eines elektrischen Gleichstroms in einem elektrischen Leiter**

(30) Priorität: 18.09.2012 DE 202012103577 U
(71) Anmelder: era-contact GmbH, 75015 Bretten (DE)
(72) Erfinder: Pesaferrer, Carles, 75015 Bretten (DE)
(74) Vertreter: Schaumburg, Thoenes, Thurn, Landskron, Eckert

(57) **Zusammenfassung**

Die Erfindung betrifft eine Vorrichtung zur Ermittlung eines elektrischen Gleichstroms in einem elektrischen Leiter, die einen Aufnahmebereich, in dem der elektrische Leiter (102) zumindest teilweise aufgenommen ist, wenn die Vorrichtung (10) an dem Leiter (102) befestigt ist, und eine Anzeigeeinheit (20) zur optischen Anzeige des Vorhandenseins eines elektrischen Gleichstroms umfasst. Mit Hilfe der Anzeigeeinheit (20) sind eine erste und mindestens eine zweite Anzeige (24, 26) anzeigbar, wobei die Vorrichtung (10) derart ausgebildet ist, dass eine für das Umschalten zwischen den Anzeigen (24, 26) benötigte Kraft durch ein Magnetfeld des durch den Leiter (102) fließenden Gleichstroms bewirkbar ist, und wobei die Anzeigeeinheit (20) mindestens ein um eine Drehachse (42) drehbar gelagertes, plättchenformiges Rotationselement (40) umfasst, das in einer ersten Position angeordnet ist, wenn der elektrische Leiter (102) von einem Gleichstrom mit einer ersten Stromstärke durchflossen ist, und das in einer zweiten Position, angeordnet ist, wenn der elektrische Leiter (102) von einem Gleichstrom mit einer zweiten Stromstärke durchflossen ist. Ferner umfasst die Vorrichtung (10) ein Gehäuse (12), das ein erstes Gehäuseteil (14) und ein zweites Gehäuseteil (16) hat, wobei das Kabel (100) in einem montierten Zustand der Vorrichtung (10) in dem Aufnahmebereich der Vorrichtung (10) aufgenommen ist, so dass das Kabel (100) vollständig von dem Gehäuse (12) umschlossen ist.

## Beschreibung

Die Erfindung betrifft eine Vorrichtung zur Ermittlung eines elektrischen Gleichstroms in einem elektrischen Leiter, die einen Aufnahmebereich umfasst, in dem der elektrische Leiter zumindest teilweise aufgenommen ist, wenn die Vorrichtung an dem Leiter befestigt ist. Ferner hat die Vorrichtung eine Anzeigeeinheit zur optischen Anzeige des Vorhandenseins eines elektrischen Gleichstroms in dem Leiter.

Insbesondere bei elektrischen Leitern die von großen elektrischen Strömen, beispielsweise von Strömen im Bereich von 800 A, durchflossen sind, ist es wichtig, das eine den elektrischen Leiter handhabende Person weiß, ob diese mit einem Strom durchflossen ist oder nicht. Aus Sicherheitsgründen ist es beispielsweise wichtig, dass diese Person den Stecker nur dann zieht bzw. einsteckt, wenn kein elektrischer Strom fließt.

Hierzu sind Vorrichtungen zur Ermittlung von elektrischen Gleichströmen bekannt, die direkten Kontakt zu dem stromdurchflossenen Leiter benötigen, um hierüber den elektrischen Stromfluss zu ermitteln und dies optisch an eine Bedienperson anzuzeigen.

Des Weiteren sind Vorrichtungen bekannt, die das Vorhandensein des elektrischen Stroms berührungslos ermitteln können. Solche Vorrichtungen weisen insbesondere magnetische Sensoren, z.B. Hall-Sensoren oder magnetische Resistoren auf, mit deren Hilfe ermittelt wird, ob der elektrische Leiter von einem Strom durchflossen ist oder nicht. Nachteilig an solchen bekannten berührungslosen Vorrichtungen ist, dass diese eine eigene Spannungsversorgung, z.B. über eine Batterie, benötigen. Es ist notwendig, dass die Batterie regelmäßig gewechselt wird. Erfolgt dies nicht, können die Vorrichtungen nicht anzeigen, ob der Leiter vom elektrischen Strom durchflossen ist oder nicht, so dass ein Sicherheitsrisiko für die Person besteht.

Es ist Aufgabe der Erfindung, eine Vorrichtung zur Ermittlung eines elektrischen Gleichstroms in einem elektrischen Leiter anzugeben, mit deren Hilfe auf einfache zuverlässige Weise ermittelt werden kann, ob der elektrische Leiter von einem elektrischen Strom einer vorbestimmten Stromstärke durchflossen ist.

Diese Aufgabe wird durch eine Vorrichtung mit den Merkmalen des Anspruchs 1 gelöst. Vorteilhafte Weiterbildungen der Erfindung sind in den abhängigen Ansprüchen angegeben.

Erfindungsgemäß ist die Vorrichtung derart ausgebildet, dass eine zum Verstellen der Anzeigeeinheit notwendige Kraft durch ein durch den Gleichstrom des Leiters erzeugtes Magnetfeld hervorgerufen wird. Insbesondere wird die für die Anzeige von der Anzeigeeinheit benötigte Energie kontaktlos von dem Leiter an die Vorrichtung übertragen. Dies hat gegenüber bekannten berührungslosen Vorrichtungen den Vorteil, dass die Vorrichtung keine eigene Energieversorgung, beispielsweise über eine Batterie, benötigt, so dass die Vorrichtung ohne regelmäßige Wartung und ohne regelmäßigen Austausch der Energieversorgung jederzeit an beliebigen Orten eingesetzt werden kann. Somit wird eine sichere zuverlässige Anzeige des Vorhandenseins des elektrischen Gleichstroms sichergestellt.

Gegenüber von bekannten Vorrichtungen, bei denen zur Ermittlung des Vorhandensein eines Stroms ein direkter Kontakt zu dem stromdurchflossenen Leiter notwendig ist, hat die Vorrichtung den Vorteil, dass eben solcher direkter Kontakt hergestellt werden muss, wodurch die Bediensicherheit erhöht wird.

Die Vorrichtung ist vorzugsweise derart ausgebildet, dass die Energie mittels Induktion von dem elektrischen Leiter an die Vorrichtung übertragbar ist. Somit wird eine besonders einfache sichere Energieübertragung erreicht.

Bei einer besonders bevorzugten Ausführungsform umfasst die Anzeigeeinheit mindestens ein um eine Drehachse drehbar gelagertes Rotationselement, das in einer ersten Position angeordnet ist, wenn der elektrische Leiter von einem Gleichstrom mit einer ersten Stromstärke durchflossen ist. Ist der Leiter dagegen von einem Gleichstrom mit einer zweiten Stromstärke durchflossen, ist das Rotationselement in einer zweiten Position angeordnet, in der es gegenüber der ersten Position um einen vorbestimmten Winkel um den Drehpunkt gedreht ist.

Es ist besonders vorteilhaft, wenn die Vorrichtung derart ausgebildet ist, dass das Rotationselement immer in der ersten Position angeordnet ist, wenn der Gleichstrom in dem elektrischen Leiter kleiner oder gleich einer vorbestimmten Grenzstromstärke ist und immer in der zweiten Position angeordnet ist, wenn der elektrische Leiter von einem Gleichstrom mit einer Stromstärke größer der vorbestimmten Grenzstromstärke durchflossen ist.

Hierdurch wird auf einfache Weise sichergestellt, dass die Bedienperson zuverlässig erkennen kann, ob der den elektrischen Leiter durchfließende elektrische Strom diese Grenzstromstärke überschreitet oder nicht.

Bei einer alternativen Ausführungsform der Erfindung kann die Anzeigeeinheit derart ausgebildet sein, dass mit ihrer Hilfe nicht nur zwischen zwei Zuständen, also dem Über- und Unterschreiten einer Grenzstromstärke, unterschieden werden kann, sondern mehr als zwei Bereiche der Stromstärke unterschieden werden können. Hierbei ist insbesondere für jeden der Bereiche eine jeweilige Position des Rotationselementes vorbestimmt, wobei in Abhängigkeit der jeweiligen Position des Rotationselementes die Anzeigeeinheit eine andere Anzeige liefert. Somit können über die Vorrichtung detaillierte Informationen über den den elektrischen Leiter durchfließenden Strom angezeigt werden.

Die Grenzstromstärke hat insbesondere einen Wert zwischen 150 A und 250 A, vorzugsweise einen Wert von etwa 200 A. Somit kann über die Vorrichtung auf einfache Weise zuverlässig angezeigt werden, ob der den elektrischen Leiter durchfließenden Strom die Stromstärke von über 200 A aufweist. Ist dies der Fall, kann die den Leiter handhabende Person entsprechende Sicherheitsvorkehrungen treffen, insbesondere den Leiter nur dann handhaben, wenn die Stromstärke unter den kritischen Wert von 200 A gesunken ist. Alternativ kann die Grenzstromstärke auch 0 A betragen, so dass mit Hilfe der Vorrichtung anzeigbar ist, ob der Leiter überhaupt von einem elektrischen Strom durchflossen ist oder nicht.

Das Rotationselement umfasst insbesondere mindestens ein ferromagnetisches Material. Alternativ kann das Rotationselement auch als Dauermagnet ausgebildet sein.

Das Rotatationselement ist vorzugsweise derart ausgebildet und/oder gelagert, dass es, wenn sich die Stromstärke des Gleichstroms des elektrischen Leiters von der ersten Stromstärke in die zweite Stromstärke ändert bzw. die Grenzstromstärke überschritten wird, aufgrund der des durch den Gleichstrom erzeugten magnetischen Feldes von der ersten in die zweite Position bewegt wird. Somit erfolgt das Verstellen des Rotationselementes von der ersten in die zweite Position durch das Magnetfeld des elektrischen Leiters, so dass keine eigene Energieversorgung für die Vorrichtung benötigt wird.

Ferner ist es vorteilhaft, wenn eine Rückstelleinheit vorgesehen ist, die das Rotationselement von der zweiten in die erste Position dreht, wenn sich die Stromstärke des Gleichstroms des elektrischen Leiters von der zweiten Stromstärke in die erste Stromstärke ändert bzw. die Grenzstromstärke erreicht oder unterschritten wird. Durch diese Rückstelleinheit wird sichergestellt, dass das Rotationselement, wenn es zuvor durch Überschreiten der Grenzstromstärke bzw. Erreichen der zweiten Stromstärke von der ersten in die zweite Position gedreht wurde beim Unterschreiten der jeweiligen Grenzstromstärke auch zuverlässig wieder zurückgedreht wird. Somit wird ein reversibler Anzeigevorgang sichergestellt.

Die Rückstelleinheit kann beispielsweise einen oder zwei Magneten umfassen, die derart ausgebildet und angeordnet sind, dass das Rotationselement durch sie in der ersten Position gehalten ist. Wenn die Stromstärke des den elektrischen Leiter durchfließenden elektrischen Strom die Grenzstromstärke überschreitet, ist die durch das durch den elektrischen Strom des Leiters erzeugten Magnetfeld wirkende Kraft größer als die Rückhaltekraft der Magneten der Rückstelleinheit, so dass das Rotationselement von der ersten in die zweite Position entgegen der Magnetkräfte der Magneten der Rückstelleinheit bewegt wird. Unterschreitet dagegen die Stromstärke wieder die Grenzstromstärke, so ist die durch die Magneten der Rückstelleinheit ausgewirkte Rückstellkraft größer als die durch das Magnetfeld des elektrischen Stroms erzeugte Kraft, so dass das Rotationselement wieder von der zweiten in die erste Position gedreht wird.

Über die Stärke der verwendeten Magneten der Rückstelleinheit und/oder deren Anordnung kann insbesondere der Wert der Grenzstromstärke vorbestimmt werden.

Bei einer alternativen Ausführungsform der Erfindung kann anstelle der Magneten auch ein elastisches Element, beispielsweise eine Feder, vorgesehen sein, durch das das Rotationselement in einer ersten Position vorgespannt ist. Diese Feder ist insbesondere derart dimensioniert, dass ihre Rückstellkraft geringer ist als die Kraft, die durch das Magnetfeld des im Leiter fließenden elektrischen Strom beim Überschreiten der Grenzstromstärke auf das Rotationselement ausgeübt wird, so dass sich dieses entgegen der Rückstellkraft der Feder von der ersten in die zweite Position bewegen kann.

Das Rotationselement ist insbesondere plättchenförmig ausgebildet, wobei die Drehachse, um die das Rotationselement gedreht wird, insbesondere mit einer der Längsachse des plättchenförmigen Rotationselementes zusammenfällt, so dass das Rotationselement um eine seine Längsachsen drehbar ist.

Ferner ist es vorteilhaft, wenn das Rotationselement derart ausgebildet ist, dass die Anzeigeeinheit eine erste Anzeige anzeigt, wenn das Rotationselement in einer ersten Position angeordnet ist, und eine zweite Anzeige anzeigt, wenn das Rotationselement in einer zweiten Position angeordnet ist.

Die zweite Anzeige ist insbesondere auf dem Rotationselement aufgebracht und nur dann durch ein Sichtfenster der Anzeigeeinheit sichtbar, wenn das Rotationselement in der zweiten Position angeordnet ist. Das Sichtfenster ist insbesondere als eine Aussparung in einem Gehäuse der Vorrichtung ausgebildet, in der ein durchsichtiges Element angeordnet ist. Die zweite Anzeige kann insbesondere auf das Rotationselement auf einer seiner großflächigen Seiten aufgedruckt sein.

Die erste Anzeige ist insbesondere an einer dem Sichtfenster gegenüberliegenden Rückseite der Anzeigeeinheit angeordnet, wobei das Rotationselement zwischen dieser Rückseite und dem Sichtfenster angeordnet ist. In der ersten Position ist das Rotationselementes derart gedreht, dass es die Sicht auf die Rückseite der Anzeigeeinheit nicht oder nur minimal behindert, so dass die erste Anzeige an der Rückseite durch das Sichtfenster mindestens teilweise, vorzugsweise nahezu vollständig, sichtbar ist. Hierzu ist das Rotationselement insbesondere in der ersten Position gegenüber der zweiten Position in einem Winkel von etwa 90° gedreht.

Hierdurch wird erreicht, dass eine das Sichtfenster betrachtende Position, wenn das Rotationselement in der zweiten Position angeordnet ist, auf die Seite des Rotationselementes schaut, auf der die zweite Anzeige aufgebracht ist. Hierbei verdeckt das Rotationselement insbesondere die Rückseite vollständig, so dass die erste Anzeige nicht sichtbar ist. Umgekehrt ist das Rotationselement in der ersten Position derart angeordnet, dass es mit seiner dünnen Seite dem Sichtfenster zugewandt ist, so dass es lediglich als ein dünner Strich sichtbar ist und ansonsten den Blick auf die an der Rückseite der Anzeigeeinheit angebrachte erste Anzeige frei gibt. So wird ein besonders einfacher und zuverlässiger Aufbau erreicht, der wenig störungsanfällig ist und keine elektrischen Anzeigeelemente umfasst.

Die erste Anzeige ist insbesondere in Form einer grün eingefärbten Fläche ausgebildet, so dass über diese grüne Fläche intuitiv symbolisiert wird, dass die Handhabung des Leiters gefahrlos durchgeführt werden kann. Die zweite Anzeige kann entsprechend als eine rot eingefärbte Fläche ausgebildet sein, so dass der Bedienperson intuitiv angezeigt wird, dass die Handhabung des Leiters mit einer Gefahr verbunden ist. Alternativ kann auch ein Warndreieck und/oder ein Blitzsymbol als zweite Anzeige auf dem Rotationselement aufgebracht sein. Ebenso ist eine Kombination aus einer roten Fläche mit einem Warndreieck und/oder einem Blitzsymbol möglich.

Bei einer besonders bevorzugten Ausführungsform der Erfindung umfasst die Vorrichtung eine Vielzahl von Sichtfenstern, hinter denen jeweils ein Rotationselement angeordnet ist, welches nach dem zuvor beschriebenen Prinzip das Vorhandensein des elektrischen Gleichstroms anzeigt. Hierdurch wird erreicht, dass unabhängig vom Betrachtungswinkel, mit dem auf die an dem Leiter befestigte Vorrichtung geschaut wird, erkannt werden kann, ob ein elektrischer Gleichstrom fließt.

Die Vorrichtung ist insbesondere derart ausgebildet, dass sie den elektrischen Leiter in einem Teilbereich vollständig umschließt, wenn sie an diesem elektrischen Leiter befestigt ist. Die Sichtfenster sind hierbei insbesondere gleichmäßig um den Radius der Anzeigevorrichtung verteilt.

Der elektrische Leiter ist insbesondere Teil eines Kabels. Die Vorrichtung ist dann nicht unmittelbar am Leiter, sondern an der Ummantelung des Kabels befestigt.

Weitere Merkmale und Vorteile der Erfindung ergeben sich aus der folgenden Beschreibung, die die Erfindung anhand von Ausführungsbeispielen im Zusammenhang mit den beigefügten Figuren näher erläutert.

Es zeigen:
- Fig. 1: eine schematische Seitenansicht eines Kabels und einer Vorrichtung zur Ermittlung eines Gleichstroms in dem Kabel in einem ersten Betriebszustand;
- Fig. 2: eine schematische Seitenansicht des Kabels und der Vorrichtung in einem zweiten Betriebszustand;
- Fig. 3: eine schematische, perspektivische Darstellung des Kabels und der Vorrichtung nach Figur 1 und 2 im ersten Betriebszustand;
- Fig. 4: eine schematische, perspektivische Darstellung des Kabels und der Vorrichtung nach den Figuren 1 bis 3 im zweiten Betriebszustand;
- Fig. 5: eine Vorderansicht des Kabels und der Vorrichtung nach den Figuren 1 bis 4;
- Fig. 6: eine Seitenansicht der Vorrichtung und des Kabels nach den Figuren 1 bis 5;
- Fig. 7: eine Schnittdarstellung der Vorrichtung und des Kabels nach den Figuren 1 bis 6 im ersten Betriebszustand;
- Fig. 8: eine Schnittdarstellung der Vorrichtung und des Kabels nach den Figuren 1 bis 7 im zweiten Betriebszustand;
- Fig. 9: eine weitere Schnittdarstellung des Kabels und der Vorrichtung nach den Figuren 1 bis 8 im ersten Betriebszustand;
- Fig. 10: eine Darstellung des Magnetfeldes des stromdurchflossenen Kabels;
- Fig. 11: einen Ausschnitt der Darstellung des Magnetfeldes nach Figur 10; und
- Fig. 12: einen weiteren Ausschnitt des Magnetfeldes nach Figur 10.

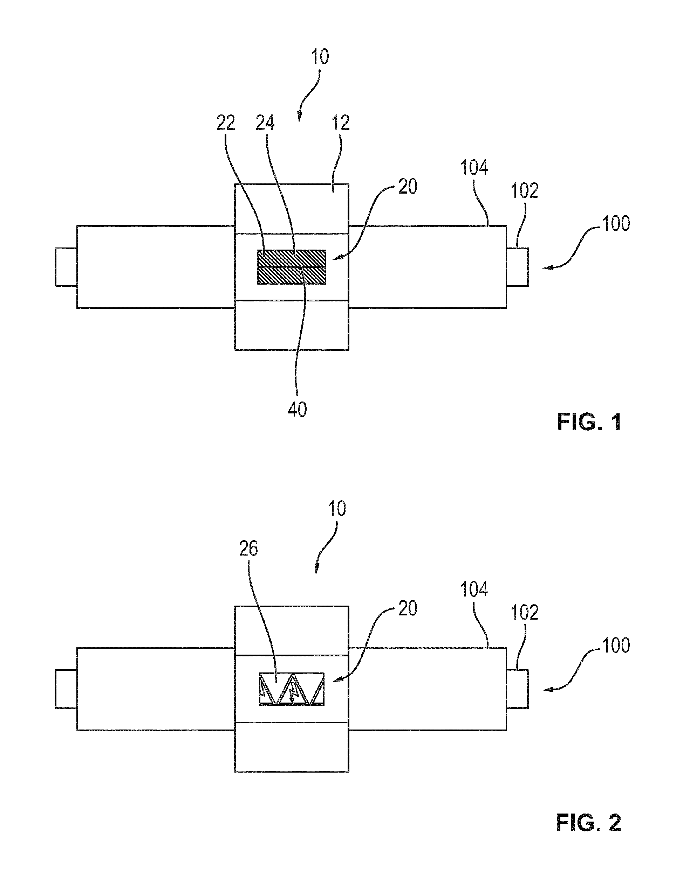

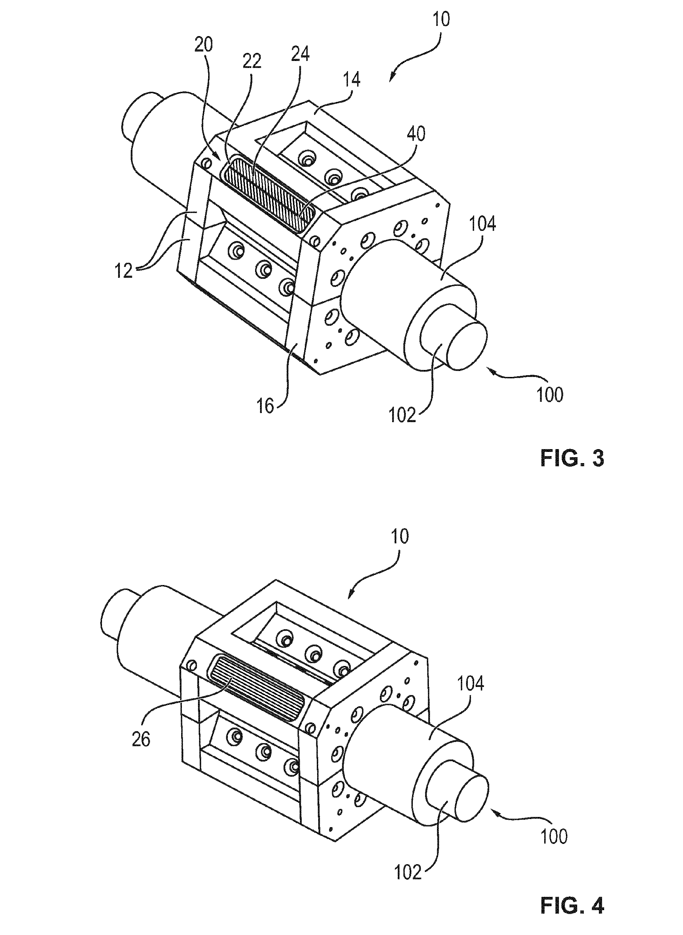

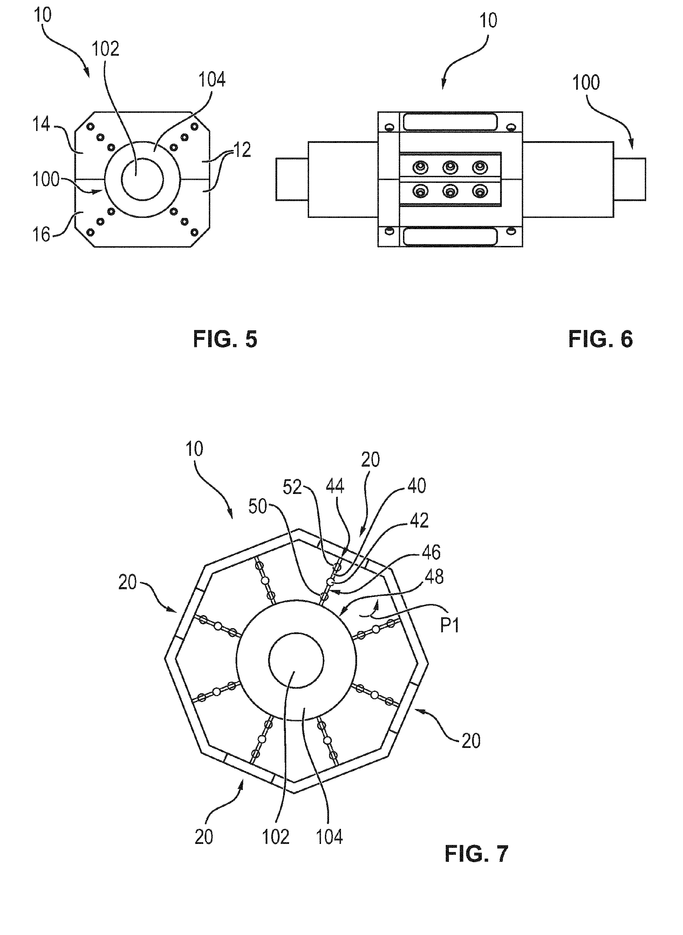

In Figur 1 ist eine Seitenansicht einer schematischen Darstellung eines Kabels 100 sowie einer Vorrichtung 10 zur Ermittlung einer elektrischen Spannung in einem elektrischen Leiter 102 des Kabels 100 in einem ersten Betriebszustand dargestellt. Figur 2 zeigt eine Seitenansicht des Kabels 100 und der Vorrichtung 10 in einem zweiten Betriebszustand. In den Figuren 3 und 4 ist jeweils eine schematische, perspektivische Darstellung der Vorrichtung 10 und des Kabels 100 gezeigt, wobei in Figur 3 der erste Betriebszustand und in Figur 4 der zweite Betriebszustand gezeigt sind. Figur 5 zeigt eine Vorderansicht des Kabels 100 und der Vorrichtung 10, Figur 6 eine weitere Seitenansicht.

Das Kabel 100 umfasst einen elektrischen Leiter 102, beispielsweise einen Draht, und eine Ummantelung 104, die insbesondere zur Isolation des elektrischen Leiters 102 dient. Mit Hilfe der Vorrichtung 10 kann einer Bedienperson angezeigt werden, ob der Leiter 102 von einem elektrischen Gleichstrom mindestens einer vorbestimmten Grenzstromstärke durchflossen ist oder nicht, so dass die Bedienperson weiß, ob sie das Kabel 100 gefahrlos handhaben kann oder nicht.

Die Vorrichtung 10 umfasst ein Gehäuse 12, das ein erstes Gehäuseteil 14 und ein zweites Gehäuseteil 16 hat, die voneinander trennbar und miteinander verbindbar sind. In dem in den Figuren 1 bis 6 montierten Zustand sind die beiden Gehäuseteile 14 und 16 miteinander verbunden, wobei das Kabel 100 in einem Aufnahmebereich der Vorrichtung 10 aufgenommen ist. Der Aufnahmebereich ist insbesondere derart ausgebildet, dass die Vorrichtung 10 das Kabel 100 vollständig umschließt und insbesondere durch eine Presspassung rutschfest auf ihm befestigt ist.

Die Vorrichtung 10 umfasst eine Anzeigeeinheit 20, die ein Sichtfenster 22 hat, über das die Bedienperson eine Anzeige sehen kann, die ihm anzeigt, ob der Leiter 102 mit einem Gleichstrom mindestens der vorbestimmten Grenzstromstärke durchflossen ist.

In den Figuren 1 und 3 ist jeweils ein erster Betriebszustand dargestellt, bei dem der den Leiter 102 durchfließende Gleichstrom eine Stromstärke hat, die kleiner oder gleich der vorbestimmten Grenzstromstärke ist. Dies wird durch das Anzeigen einer ersten Anzeige 24 in dem Sichtfenster 22 angezeigt. Diese erste Anzeige ist insbesondere in Form einer grünen Fläche ausgebildet, so dass die Bedienperson intuitiv wahrnimmt, dass sie das Kabel 100 gefahrlos handhaben kann.

In den Figuren 2 und 4 ist jeweils ein zweiter Betriebszustand dargestellt, in dem der Leiter 102 von einem Gleichstrom durchflossen ist, dessen Stromstärke größer als die vorbestimmte Grenzstromstärke ist. Dies wird durch das Anzeigen einer zweiten Anzeige 26 in dem Sichtfenster 22 angezeigt. Bei dem in Figur 2 gezeigten Ausführungsbeispiel ist die zweite Anzeige 26 in Form von Dreiecken mit einem Blitzsymbol ausgebildet. Bei der in Figur 4 gezeigten Ausführungsform dagegen ist die zweite Anzeige 26 in Form einer rot eingefärbten Fläche ausgebildet. In beiden Fällen wird durch die verwendete zweite Anzeige 26 intuitiv das Vorhandensein einer Gefahr vermittelt. Alternativ kann auch eine Kombination einer rot eingefärbten Fläche mit Warndreiecken und/oder Blitzsymbolen verwendet werden. Auch können beliebige andere erste Anzeigen 24 und zweite Anzeigen 26 verwendet werden. Beispielsweise kann auch jeweils ein vorbestimmter Text angezeigt werden.

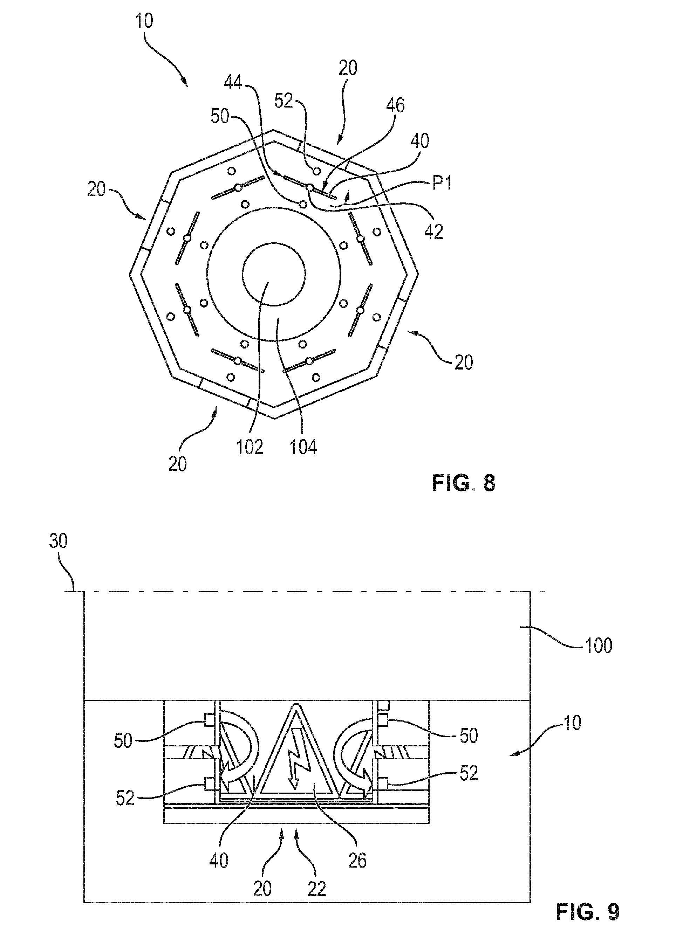

Im Folgenden wird im Zusammenhang mit den Figuren 7 bis 9 die Funktionsweise der Anzeigeeinheit 20 der Vorrichtung 10 dargestellt. Die Figuren 7 und 8 zeigen hierbei jeweils eine Schnittdarstellung durch den Querschnitt des Kabels 100 und der Vorrichtung 10, wobei Figur 9 einen Längsschnitt entlang der Längsachse 30 des Kabels 100 zeigt. In den Figuren 7 und 9 ist der erste Betriebszustand, in der Figur 8 der zweite Betriebszustand gezeigt.

Wie den Figuren 7 und 8 zu entnehmen ist, umfasst die Vorrichtung 10 nicht nur eine Anzeigeeinheit 20 sondern vier Anzeigeeinheiten 20, die insbesondere baugleich ausgebildet sind. Die Anzeigeeinheiten 20 sind hierbei vorzugsweise gleichmäßig um den Umfang der Vorrichtung 10 verteilt, so dass, unabhängig vom Betrachtungswinkel, eine Bedienperson über die Vorrichtung 10 zuverlässig ablesen kann, ob der den Leiter 102 durchfließende Gleichstrom den Grenzwert überschreitet oder nicht.

Bei einer alternativen Ausführungsform können auch weniger als vier Anzeigeeinheiten 20 oder mehr als vier Anzeigeeinheiten 20 vorgesehen sein. Ebenso kann deren Verteilung ungleichmäßig sein.

Im Folgenden wird die Funktionsweise der Anzeigeeinheiten 20 beispielhaft an einer dieser Anzeigeeinheiten 20 erläutert. Die anderen Anzeigeeinheiten 20 sind vorzugsweise analog aufgebaut.

Die Anzeigeeinheit 20 umfasst ein Rotationselement 40, das um eine Drehachse 42 drehbar gelagert ist. Das Rotationselement 40 ist hierbei insbesondere plättchenförmig ausgebildet, und umfasst somit eine schmale Stirnseite 44 und eine flächige Seite 46.

Bei dem in Figur 7 dargestellten ersten Betriebszustand, d.h. wenn der Leiter 102 von einem Gleichstrom kleiner oder gleich der Grenzstromstärke durchflossen ist, ist das Rotationselement 40 in einer ersten Position angeordnet, in dem seine schmale Stirnseite 44 zum Sichtfenster 22 gerichtet ist. Somit sieht eine auf das Sichtfenster 22 blickende Person das Rotationselement 40 lediglich als einen schmalen Streifen, wie dies beispielsweise in Figur 1 und Figur 3 gezeigt ist. Somit gibt das Rotationselement 40 der ersten Position die Sicht auf eine Rückseite 48 der Anzeigeeinheit 20 frei, in der die erste Anzeige 24 angeordnet ist. Dadurch blickt eine durch das Sichtfenster 22 schauende Person beidseitig an dem Rotationselement 40 vorbei auf die Rückseite 48 der Anzeigeeinheit 20, die grün eingefärbt ist.

Ferner umfasst die Anzeigeeinheit 20 zwei Magneten 50, 52, die derart ausgebildet und angeordnet sind, dass sie das ferromagnetische Rotationselement 40 in der ersten Position halten. Alternativ kann anstelle der Magneten 50, 52 auch ein elastisches Element, beispielsweise eine Feder, verwendet werden. Ebenso kann auch nur ein Magnet 50, 52 oder mehr als zwei Magneten 50, 52 verwendet werden. An Stelle eines ferromagnetischen Rotationselementes 40 kann auch ein Permanentmagnet genutzt werden.

Wenn der elektrische Leiter 102 von einem Gleichstrom durchflossen wird ist er von einem Magnetfeld umgeben, durch das auf die in ihm angeordneten ferromagnetischen Rotationselemente 40 eine Kraft ausgeübt wird, die derart ausgebildet ist, dass sie eine Rotationsbewegung des Rotationselementes 40 um seine Drehachse 42 bewirkt, wie dies in Figur 7 und 8 durch den Pfeil P1 angedeutet ist. Wenn die Stromstärke des Gleichstroms im elektrischen Leiter 102 die vorbestimmte Grenzstromstärke überschreitet, ist die durch das magnetische Feld bewirkte Kraft größer als die Rückhaltekraft der Magnete 50, 52, so dass beim Überschreiten dieser vorbestimmten Grenzstromstärke das Rotationselement 40 in Richtung des Pfeiles P1 gedreht wird, bis es in der in Figur 8 gezeigten zweiten Position angeordnet ist. Das Rotationselement ist in der zweiten Position insbesondere um einen Winkel von 90° gegenüber der ersten Position gedreht.

Unterschreitet die Stromstärke des Gleichstroms des Leiters 102 wieder die Grenzstromstärke, so wird das Rotationselement 40 entgegen der Richtung des Pfeiles P1 durch die Magneten 50, 52 wieder zurück in die erste Position bewegt.

In der zweiten Position ist das Rotationselement 40 derart angeordnet, dass eine durch das Sichtfenster 22 blickende Person die flächige Seite 46 sieht. Hierbei ist das Rotationselement 40 insbesondere so breit ausgebildet, dass der Blick auf die Rückseite 48 durch es vollständig versperrt wird, so dass die auf der Rückseite 48 angebrachte erste Anzeige 24 nicht sichtbar ist. Vielmehr ist auf der flächigen Seite 46 die zweite Anzeige 26 aufgebracht, so dass in dem zweiten Betriebszustand eine durch das Sichtfenster 22 blickende Person diese zweite Anzeige 26 sieht.

Somit wird erreicht, dass auf einfache Weise über die beiden Anzeigen 24, 26 angezeigt werden kann, ob der den Leiter 102 durchfließenden Gleichstrom die Grenzstromstärke überschreitet oder nicht. Es ist besonders vorteilhaft, dass die Vorrichtung 10 rein passiv arbeitet, d.h. dass keine eigene Energieversorgungseinheit, wie beispielsweise einer Batterie, notwendig ist. Ebenso ist kein direkter Kontakt zu dem Leiter 102 notwendig. Das Verstellen der Anzeigeeinheit 20 zwischen der ersten Anzeige 24 und der zweiten Anzeige 26 erfolgt alleine durch die über das Magnetfeld des elektrischen Leiters 102 bewirkte Kraft auf das Rotationselement 40. Somit wird eine sichere wartungsarme Funktionsweise erzielt.

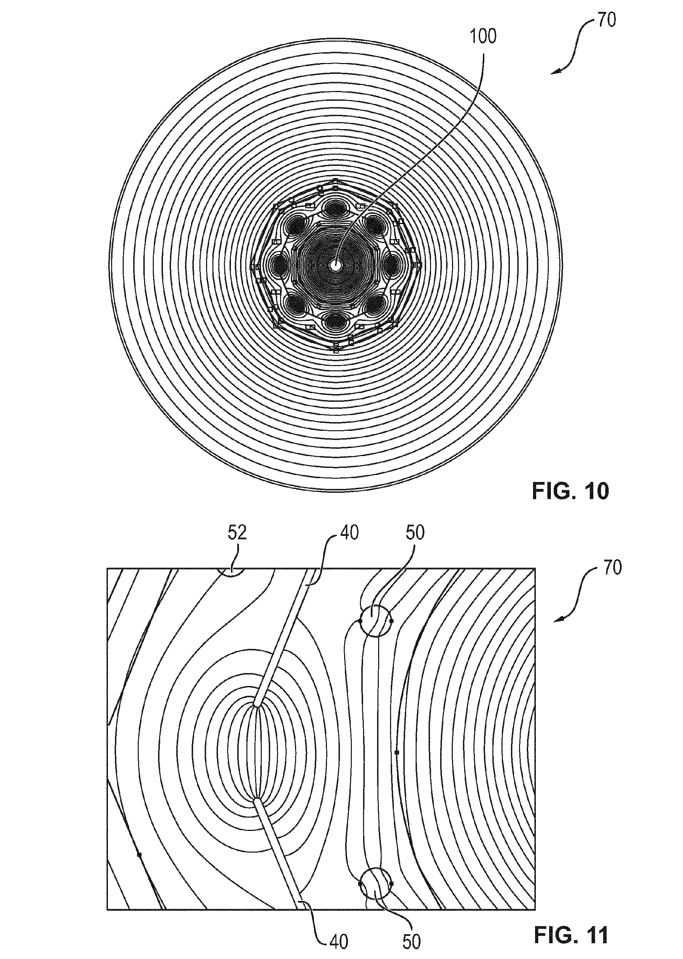

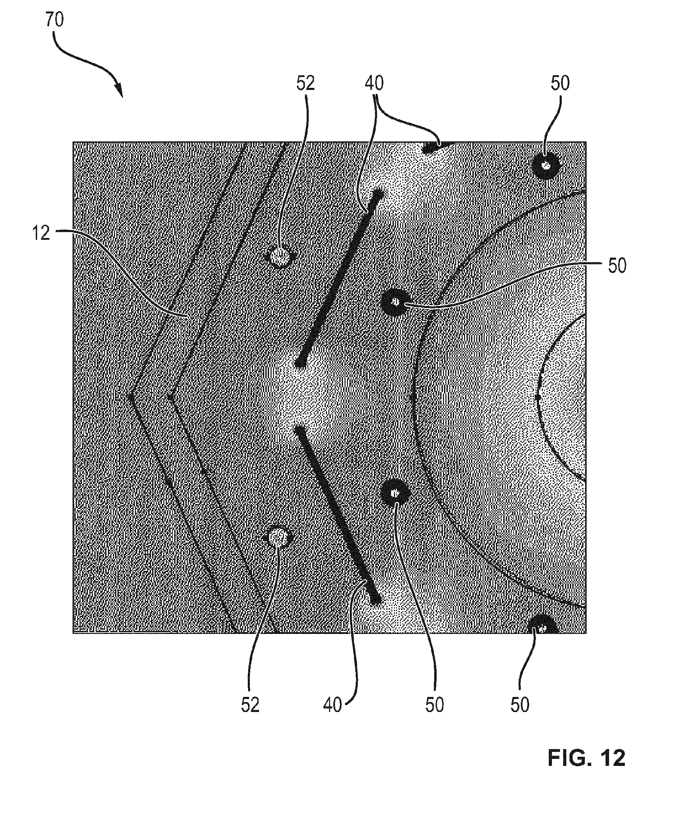

In der Figur 10 ist eine schematische Darstellung einer Simulation des Magnetfeldes 70, das von dem stromdurchflossenen Leiter 102 und den Magneten 50, 52 erzeugt wird, dargestellt. Die Figuren 11 und 12 zeigen hierbei jeweils Ausschnitte des Magnetfeldfeldes 70.

Bei einer alternativen Ausführungsform der Erfindung sind die Anzeigeeinheiten 20 auch derart ausgebildet, dass mehr als nur zwei Betriebszustände dargestellt werden können. Hierzu sind das Rotationselement 40 und die Magneten 50, 52 insbesondere derart ausgebildet und angeordnet, dass je nach der Stromstärke des durch den Leiter 102 fließenden Gleichstroms mehr als zwei vorbestimmte Positionen eingenommen werden können und entsprechend jeweils eine andere Anzeige 24, 26 durch das Sichtfenster 22 sichtbar ist.

## Patentansprüche

1. Vorrichtung zur Ermittlung eines elektrischen Gleichstroms in einem elektrischen Leiter,
mit einem Aufnahmebereich, in dem der elektrische Leiter (102) zumindest teilweise aufgenommen ist, wenn die Vorrichtung (10) an dem Leiter (102) befestigt ist, und
mit einer Anzeigeeinheit (20) zur optischen Anzeige des Vorhandenseins eines elektrischen Gleichstroms in dem Leiter (102),
wobei mit Hilfe der Anzeigeeinheit (20) eine erste Anzeige (24) und mindestens eine zweite Anzeige (26) anzeigbar sind,
wobei die Vorrichtung (10) derart ausgebildet ist, dass eine für das Umschalten zwischen der ersten Anzeige (24) und der zweiten Anzeige (26) benötigte Kraft durch ein Magnetfeld des durch den Leiter (102) fließenden Gleichstroms bewirkbar ist,
wobei die Anzeigeeinheit (20) mindestens ein um eine Drehachse (42) drehbar gelagertes Rotationselement (40) umfasst, das in einer ersten Position angeordnet ist, wenn der elektrische Leiter (102) von einem Gleichstrom mit einer ersten Stromstärke durchflossen ist, und das in einer zweiten Position, in der es um einen vorbestimmten Winkel gegenüber der ersten Position gedreht ist, angeordnet ist, wenn der elektrische Leiter (102) von einem Gleichstrom mit einer zweiten Stromstärke durchflossen ist,
wobei das Rotationselement (40) plättchenformig ist, und
wobei die Vorrichtung (10) ein Gehäuse (12) umfasst, das ein erstes Gehäuseteil (14) und ein zweites Gehäuseteil (16) hat, die voneinander trennbar und miteinander verbindbar sind, wobei das Kabel (100) in einem montierten Zustand der Vorrichtung (10) in dem Aufnahmebereich der Vorrichtung (10) aufgenommen ist, so dass das Kabel (100) vollständig von dem Gehäuse (12) umschlossen ist.

2. Vorrichtung (10) nach Anspruch 1, **dadurch gekennzeichnet, dass** die Vorrichtung (10) derart ausgebildet ist, dass sämtliche von ihr benötigte Energie von dem Leiter (102) kontaktlos an sie übertragbar ist.

3. Vorrichtung (10) nach Anspruch 1 oder 2, **dadurch gekennzeichnet, dass** die Anzeigeeinheit (20) mindestens ein um eine Drehachse drehbargelagertes Rotationselement (40) umfasst, das in einer ersten Position angeordnet ist, wenn der elektrische Leiter (102) von einem Gleichstrom mit einer Stromstärke kleiner oder gleich einer vorbestimmten Grenzstromstärke durchflossen ist, und das in einer zweiten Position, in der es um einen vorbestimmten Winkel gegenüber der ersten Position gedreht ist, angeordnet ist, wenn der elektrische Leiter (102) von einem Gleichstrom mit einer Stromstärke größer der vorbestimmten Grenzstromstärke durchflossen ist.

4. Vorrichtung (10) nach Anspruch 3, **dadurch gekennzeichnet, dass** die Grenzstromstärke einen Wert zwischen 150 A und 250 A, insbesondere einen Wert von 200 A, hat.

5. Vorrichtung (10) nach einem der vorhergehenden Ansprüche, **dadurch gekennzeichnet, dass** das Rotationselement (40) mindestens ein ferromagnetisches Material und/oder mindestens einen Permanentmagneten umfasst.

6. Vorrichtung (10) nach einem der vorhergehenden Ansprüche, **dadurch gekennzeichnet, dass** das Rotationselement (40) derart ausgebildet und/oder gelagert ist, dass es, wenn sich die Stromstärke des Gleichstroms des elektrischen Leiters (102) von der ersten Stromstärke in die zweite Stromstärke ändert bzw. die Grenzstromstärke überschritten wird, aufgrund des durch den Gleichstrom bewirkten magnetischen Feldes (70) von der ersten in die zweite Position bewegt wird.

7. Vorrichtung (10) nach einem der vorhergehenden Ansprüche, **dadurch gekennzeichnet, dass** eine Rückstelleinheit (50, 52) vorgesehen ist, die das Rotationselement (40) in der ersten Position hält und/oder die das Rotationselement (40) von der zweiten Position in die erste Position dreht, wenn sich die Stromstärke des Gleichstroms des elektrischen Leiters (102) von der zweiten Stromstärke in die ersten Stromstärke ändert bzw. die Grenzstromstärke erreicht oder unterschritten wird.

8. Vorrichtung (10) nach Anspruch 7, **dadurch gekennzeichnet, dass** die Rückstelleinheit (50, 52) mindestens einen Magneten (50, 52), vorzugsweise zwei Magneten (50, 52), umfasst.

9. Vorrichtung (10) nach Anspruch 7 oder 8, **dadurch gekennzeichnet, dass** die Rückstelleinheit ein elastischen Element, vorzugsweise eine Feder, umfasst, das das Rotationselement (40) in der ersten Position vorspannt.

10. Vorrichtung (10) nach einem der vorhergehenden Ansprüche, **dadurch gekennzeichnet, dass** das Rotationselement (40) derart ausgebildet ist, dass die Anzeigeeinheit (20) die erste Anzeige (24) anzeigt, wenn das Rotationselement (40) in der ersten Position angeordnet ist, und die zweite Anzeige (26) anzeigt, wenn das Rotationselement (40) in der zweiten Position angeordnet ist.

11. Vorrichtung (10) nach Anspruch 10, **dadurch gekennzeichnet, dass** die zweite Anzeige (26) auf dem Rotationselement (40) aufgebracht ist und durch ein Sichtfenster (22) der Anzeigeeinheit (20) sichtbar ist, wenn das Rotationselement (40) in der zweiten Position angeordnet ist.

12. Vorrichtung (10) nach Anspruch 11, **dadurch gekennzeichnet, dass** die erste Anzeige (24) an einer dem Sichtfenster (22) gegenüberliegenden Rückseite (48) der Anzeigeeinheit (20) angeordnet ist, dass das Rotationselement (40) zwischen der Rückseite (48) und dem Sichtfenster (22) angeordnet ist, und dass das Rotationselement (40) in der ersten Position derart angeordnet ist, dass die erste Anzeige (24) an der Rückseite (48) durch das Sichtfenster (22) zumindest teilweise sichtbar ist.

13. Vorrichtung (10) nach Anspruch 12, **dadurch gekennzeichnet, dass** das Rotationselement (40) in der ersten Position gegenüber der zweiten Position um einen Winkel zwischen 80° und 100°, insbesondere 90°, gedreht ist.

14. Vorrichtung (10) nach einem der Ansprüche 10 bis 13, **dadurch gekennzeichnet, dass** die erste Anzeige (24) als grün eingefärbte Fläche und/oder die zweite Anzeige (26) als rot eingefärbte Fläche und/oder Warndreieck und/oder Blitzsymbol ausgebildet sind.
